# EUROPEAN PATENT SPECIFICATION

(11) **EP 2 579 696 B1**
(45) Date of publication and mention of the grant of the patent: **05.12.2018**
(21) Application number: 11786762.2
(22) Date of filing: 27.05.2011
(51) Int. Cl.: H05K 1/09, H01L 23/373, H05K 1/02, H05K 1/03, H01L 23/00, H01L 25/065, H01L 25/07

(54) **CIRCUIT BOARD AND ELECTRONIC DEVICE USING THE SAME**
LEITERPLATTE UND ELEKTRONISCHE VORRICHTUNG DAMIT
CARTE DE CIRCUIT IMPRIMÉ ET DISPOSITIF ÉLECTRONIQUE DOTÉ D'UNE TELLE CARTE

(30) Priority: 27.05.2010 JP 2010121710
(43) Date of publication of application: 10.04.2013
(73) Proprietor: Kyocera Corporation, Kyoto 612-8501 (JP)
(72) Inventor: ABE,Yuuichi, Kirishima-shi Kagoshima 899-4396 (JP); NAKAMURA,Kiyotaka, Kirishima-shi Kagoshima 899-4396 (JP); TANIGUCHI,Youhei, Kirishima-shi Kagoshima 899-4396 (JP)
(74) Representative: Viering, Jentschura & Partner mbB Patent- und Rechtsanwälte
(86) International application number: PCT/JP2011/062243
(87) International publication number: WO 2011/149065

(56) References cited:
- EP-A1- 2 157 607
- JP-A- 8 139 420
- JP-A- 9 162 325
- JP-A- 11 121 889
- JP-A- 2000 340 912
- JP-A- 2006 066 650
- JP-A- 2006 108 464
- JP-A- 2006 128 286
- JP-A- 2006 237 383
- JP-A- 2006 282 417
- JP-A- 2007 066 995

## Description

### Technical Field

The present invention relates to a circuit board and an electronic device in which an electronic component is mounted on the circuit board.

### Background Art

Electronic devices, in which semiconductor elements such as insulated gate bipolar transistor (IGBT) elements, intelligent power module (IPM) elements, metal oxide semiconductor field-effect transistor (MOSFET) elements, light-emitting diode (LED) elements, freewheeling diode (FWD) elements, and giant transistor (GTR) elements, and various electronic components such as head elements for dye sublimation thermal printers, head elements for thermal ink-jet printers, and Peltier elements, are mounted on circuit members of circuit boards, have recently been used.

A ceramic sintered body is used as a supporting substrate for a circuit board including a circuit member where an electronic component is mounted. As a circuit board having a structure in which a ceramic sintered body and a circuit member are joined, for example, PTL 1 discloses a ceramic circuit board in which a metal circuit board is integrally bonded to a surface of an oxide layer formed on a surface of a nitride ceramic substrate with a brazing material layer containing at least one active metal selected from Ti, Zr, Hf, and Nb.

In addition, PTL 2 discloses a silicon nitride circuit board in which a plurality of semiconductor elements are mounted on a high-thermal-conductivity silicon nitride substrate with a circuit layer, the circuit board including the circuit layer joined to the high-thermal-conductivity silicon nitride substrate having a thermal conductivity of 60 W/m·K or more, containing 2.0% to 17.5% by mass of a rare-earth element on an oxide basis, and containing a total of 0.3% by mass or less of Li, Na, K, Fe, Ca, Mg, Sr, Ba, Mn, and B, which are impurities of cationic elements.

### Citation List

### Patent Literature

PTL 1: Japanese Unexamined Patent Application Publication No. 2000-272977
PTL 2: Japanese Unexamined Patent Application Publication No. 9-69590

Further relevant background art is disclosed in EP 2 157 607 A1, JP 2006-108464 A and JP 2006-128286 A.

### Summary of Invention

### Technical Problem

Due to troubles in which repetitive application of heat generated during the operation of an electronic component mounted on a circuit member causes warpage of the circuit member to make troubles, such as the detachment of a joining portion and cracking of a supporting substrate, thereby reducing the reliability including a reduction in heat dissipation properties, and a recent circuit board is required to have a low reduction in reliability. In addition, even though the heat dissipation properties are required to be enhanced, the circuit boards described in PTLs 1 and 2 have thin circuit members, and do not have high heat dissipation properties.

The present invention has been accomplished to overcome the foregoing problems. The present invention provides a highly reliable circuit board having good heat dissipation properties, in which the warpage of a circuit member due to heat generated during the operation of an electronic component mounted on the circuit member is low, and provides an electronic device including the circuit board.

### Solution to Problem

A circuit board according to the present invention includes a circuit member containing copper as a principal component on one main surface of a supporting substrate. An upper surface of the circuit member serves as a mounting surface for an electronic component. The circuit member includes a first region having a first average grain size and a second region located closer to the mounting surface side than the first region, the second region having a second average grain size smaller than the first average grain size.

An electronic device according to the present invention includes an electronic component mounted on the circuit member of the circuit board according to the present invention described above.

### Advantageous Effects of Invention

Since the circuit board according to the present invention includes a circuit member containing copper as a principal component on one main surface of a supporting substrate, an upper surface of the circuit member serving as a mounting surface for an electronic component, in which the circuit member includes a first region having a first average grain size and a second region located closer to the mounting surface side than the first region, the second region having a second average grain size smaller than the first average grain size, the second region having a small average grain size, i.e., high stiffness, is located on the mounting surface side susceptible to heat generated during the operation of the electronic component mounted on the circuit member. Thus, the warpage of the circuit member due to the heat can be reduced. The first region has a high average grain size and good thermal conductivity, compared with the second region, thereby enabling the efficient dissipation of heat transferred from the second region. Thus, the warpage of the circuit member due to heat generated during the operation of the electronic component on the circuit member is low, and heat dissipation properties are good, and therefore, the circuit board has high reliability and can be used over a long period of time.

The electronic device according to the present invention includes an electronic component mounted on the circuit member of the circuit board according to the present invention and is thus made to be highly reliable. Brief Description of Drawings

Fig. 1 shows an exemplary circuit board according to a present embodiment, (a) being a plan view, and (b) being a cross-sectional view taken along line A-A' in (a).
Fig. 2 shows an exemplary circuit board according to a present embodiment, (a) being a plan view, (b) being a cross-sectional view taken along line B-B' in (a), and(c) being a bottom plan view.
Fig. 3 shows an exemplary electronic device according to a present embodiment, (a) being a plan view, (b) being a cross-sectional view taken along line E-E' in (a), and (c) being a bottom plan view.

### Description of Embodiments

An example of the present embodiment will be described below with reference to the drawings.

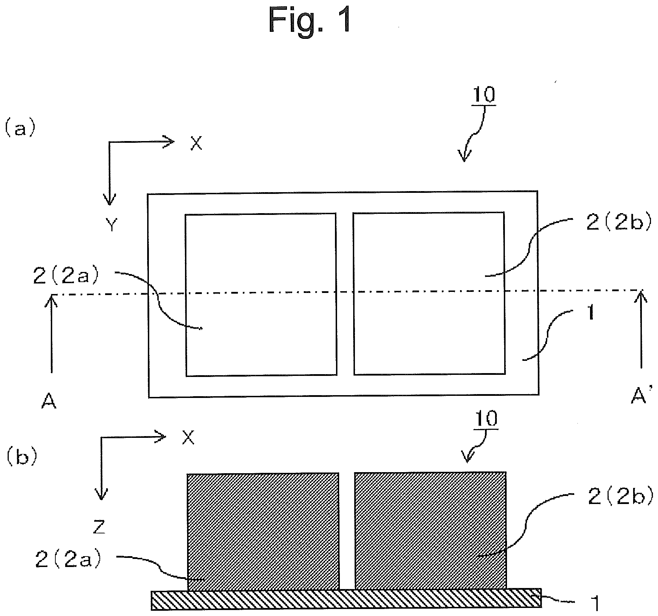

Fig. 1 shows an exemplary circuit board according to a present embodiment, (a) being a plan view, and (b) being a cross-sectional view taken along line A-A' in (a).

In a circuit board 10 exemplified in Fig. 1, circuit members 2 (2a, 2b) comprising copper as a principal component are provided on one main surface of a supporting substrate 1, upper surfaces of the circuit members 2 serve as mounting surfaces for electronic components.

Here, the supporting substrate 1 exemplified in Fig. 1 is flat. For example, the supporting substrate 1 has a length (in the X direction illustrated in Fig. 1) of 20 mm or more and 220 mm or less and a width (in the Y direction illustrated in Fig. 1) of 10 mm or more and 120 mm or less. The thickness of the supporting substrate 1 varies depending on its use. To achieve high durability, high dielectric strength, and suppressed thermal resistance, the thickness of the supporting substrate 1 is preferably 0.2 mm or more and 1.0 mm or less. With respect to dimensions of the circuit members 2a and 2b, for example, a length (in the X direction illustrated in Fig. 1) is 8 mm or more and 100 mm or less and a width (in the Y direction illustrated in Fig. 1) is 8 mm or more and 100 mm or less. Fig. 1 shows an example of the circuit members 2a and 2b having the same dimensions. Needless to say, the circuit members 2a and 2b having different dimensions may be arranged.

The thickness of each of the circuit members 2a and 2b exemplified in Fig. 1 is determined by the amount of current flowing through the circuit members 2a and 2b and the amount of heat from electronic components (not illustrated) mounted on the circuit members 2a and 2b and is, for example, 0.5 mm or more and 5 mm or less. The circuit members 2 contains copper as a principal component on the one main surface of the supporting substrate 1 may be provided by a direct joining method or an active metal brazing method.

In the circuit board 10 exemplified in Fig. 1, it is important for the circuit members 2 to include a first region having a first average grain size and a second region which is located closer to the mounting surface side than the first region and which has a second average grain size smaller than the first average grain size. In the circuit members 2 constituting the circuit board 10 according to the present embodiment, the second region with the second average grain size smaller than the first average grain size has higher stiffness than the first region having the first average grain size.

The second region with high stiffness are located on mounting surface sides susceptible to heat generated during the operation of the electronic components on the circuit members 2, thereby reducing warpage of the circuit members 2 due to the heat. To achieve the effect of reducing the warpage, the second region is preferably present over the entire corresponding mounting surface.

The first region has a large average grain size and good thermal conductivity, compared with the second region, thereby enabling the efficient dissipation of heat transferred from the second region. Thus, the warpage of the circuit members 2 due to heat generated during the operation of the electronic components on the circuit members 2 is low, and heat dissipation properties are good. Hence, the circuit board 10 has high reliability and can be used over a long period of time.

In the circuit members 2, the average grain size can be determined with reference to a cut method according to JIS H0501-1986 (ISO 2624-1973). In pretreatment, the circuit members 2 may be polished by a cross-section polishing method, and the resulting polished surfaces may be chemically etched by immersion in a solution at 40°C for 1 minute, the solution containing 50% by volume of aqueous hydrogen peroxide mixed with 50% by volume of dilute sulfuric acid.

In the circuit board 10 according to the present embodiment, the second region preferably has an average grain size of 0.1 mm or less (excluding 0 µm). When the second region has an average grain size of 0.1 mm or less (excluding 0 µm), the second region has even higher stiffness, thereby making it possible to further reduce the warpage of the circuit members 2 due to heat generated during the operation of the electronic components on the circuit members 2.

In the circuit board 10 according to the present embodiment, the first region preferably has an average grain size of more than 0.1 mm and 0.5 mm or less. When the first region has an average grain size of more than 0.1 mm and 0.5 mm or less, the first region has good thermal conductivity and makes bonding strength high to the supporting substrate 1. The bonding strength may be determined by measuring peel strength with reference to JIS C6481-1996.

With respect to a preferred configuration of the first region and the second region, preferably, the first region extends from a surface of the supporting substrate 1 side to a position corresponding to 15% to 35% of the thickness of the circuit member 2, and the second region occupies a portion other than the first region.

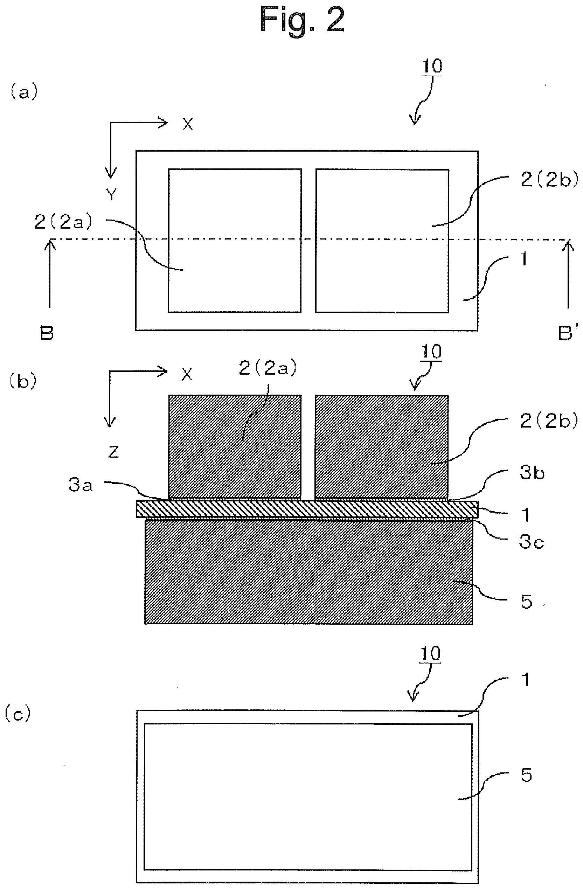

Fig. 2 shows a circuit board according to another example in the present embodiment, (a) being a plan view, (b) being a cross-sectional view taken along line B-B' in (a), and (c) is a bottom plan view.

The circuit board 10 exemplified in Fig. 2 is a circuit board 10 in which the circuit member 2 containing copper as a principal component is formed on one main surface of the supporting substrate 1; and a heat-dissipating member 5 containing copper as a principal component is formed on the other main surface of the supporting substrate 1. Fig. 2 illustrates an example in which the circuit members 2 and the heat-dissipating member 5 are joined to the supporting substrate 1 with joining layers 3a to 3c each composed of a brazing material.

Here, the supporting substrate 1 and the circuit members 2a and 2b constituting the circuit board 10 exemplified in Fig. 2 are the same as the supporting substrate 1 and the circuit members 2a and 2b constituting the circuit board 10 exemplified in Fig. 1. Thus, descriptions of the shape, the external dimensions, and the thickness are omitted. Each of the joining layers 3a and 3b has a thickness of, for example, 5 µm or more and 20 µm or less. The heat-dissipating member 5 exemplified in Fig. 2 has the function of dissipating heat generated during the operation of electronic components (not illustrated) to be mounted on the circuit members 2a and 2b. For example, the heat-dissipating member 5 has a length (in the X direction illustrated in Fig. 2) of 18 mm or more and 210 mm or less, a width (in the Y direction illustrated in Fig. 2) of 8 mm or more and 110 mm or less, and a thickness of 0.5 mm or more and 5 mm or less. The joining layer 3c has a thickness of, for example, 5 µm or more and 20 µm or less.

The circuit members 2 and the heat-dissipating member 5 containing copper as a principal component each preferably have a copper content of 90% by mass or more. Specifically, the copper may be composed of, for example, oxygen-free copper, tough pitch copper, or phosphorus-deoxidized copper. With respect to oxygen-free copper, specifically, linear crystal oxygen-free copper, monocrystalline high-purity oxygen-free copper, and vacuum melted copper having a copper content of 99.995% by mass or more are preferred. In this manner, high copper contents of the circuit members 2 and the heat-dissipating member 5 result in low electrical resistance and high thermal conductivity, thereby improving the heat dissipation properties. Furthermore, in the circuit members 2, circuit characteristics (characteristics in which a power loss due to heat from the electronic components on the circuit members 2 is reduced) are improved.

The copper content of each of the circuit members 2 and the heat-dissipating member 5 may be determined by fluorescent X-ray spectroscopy or inductively coupled plasma (ICP) spectrometry. In this case, the copper content may be determined by measuring copper using the foregoing analysis. Alternatively, the copper content may be determined by measuring components other than copper and subtracting the resulting contents of the components from 100% by mass.

The heat-dissipating member 5 of the circuit board 10 according to the present embodiment, may include a first region having a first average grain size and a second region which is located closer to an opposite surface side of the supporting substrate 1 than the first region and which has a second average grain size smaller than the first average grain size. Because of this, heat is rapidly transferred from the first region to the second region, the heat being generated during the operation of the electronic components on the circuit members 2 and transferred to the supporting substrate 1. Such good heat dissipation properties and high stiffness of the second region reduces the warpage of the heat-dissipating member 5.

The second region of the heat-dissipating member 5 preferably has an average grain size of 0.1 mm or less (excluding 0 µm). When the second region of the heat-dissipating member 5 has an average grain size of 0.1 mm or less (excluding 0 µm), the second region has higher stiffness. It is thus possible to further reduce the warpage of the heat-dissipating member 5 when heat generated during the operation of the electronic components on the circuit members 2 is transferred thereto.

The first region of the heat-dissipating member 5 preferably has an average grain size of more than 0.1 mm and 0.5 mm or less. When the first region has an average grain size of more than 0.1 mm and 0.5 mm or less, the first region has good thermal conductivity and high bonding strength to the supporting substrate 1.

In the case where the supporting substrate 1 is formed of a ceramic sintered body, a principal component of the ceramic sintered body include aluminum oxide, silicon nitride, aluminum nitride, and zirconium oxide are cited. In particular, the principal component of the ceramic sintered body is preferably aluminum oxide, silicon nitride, or aluminum nitride. In the case where the principal component is any one of these components, it is possible to achieve high heat dissipation properties and high reliability because these components have high thermal conductivity and good mechanical properties.

The ceramic sintered body contains a sintering agent that promotes sintering in a firing step. For example, in the case where the principal component of the ceramic sintered body is silicon nitride, examples of the sintering agent include oxides of rare-earth elements, magnesium oxide, calcium oxide, and the like.

With respect to mechanical properties of the ceramic sintered body, the ceramic sintered body preferably has a three-point bending strength of 750 MPa or more, a dynamic elastic modulus of 300 GPa or more, a Vickers hardness (Hv) of 13 GPa or more, and a fracture toughness (K_{1C}) of 5 MPa·m^{1/2} or more. In the case where these mechanical properties fall within the foregoing range, the circuit board 10 has improved creep resistance and durability against heat cycles. Thus, the circuit board 10 has high reliability and can be used over a long period of time.

The three-point bending strength may be measured with reference to JIS R1601-2008 (ISO 17565:2003 (MOD)). However, in the case where the ceramic sintered body has a small thickness and where a specimen cut out from the ceramic sintered body cannot have a thickness of 3 mm, the thickness of the specimen is set to the thickness of the ceramic sintered body as it is, and evaluations are performed. The evaluation results preferably satisfy the values described above.

Regarding the stiffness of the ceramic sintered body, the stiffness may be evaluated using the dynamic elastic modulus. The dynamic elastic modulus may be measured by an ultrasonic pulse method with reference to JIS R1602-1995. However, in the case where the ceramic sintered body has a small thickness and where a specimen cut out from the ceramic sintered body cannot have a thickness of 10 mm, the evaluations are performed by a cantilever resonance method. The evaluation results preferably satisfy the values described above.

The Vickers hardness (Hv) and the fracture toughness (K_{1C}) may be measured by an indentation fracture method (IF method) specified in JIS R1610-2003 (ISO 14705:2000 (MOD)) and JIS R1607-1995, respectively. In the case where the ceramic sintered body has a small thickness and where specimens cut out from the ceramic sintered body cannot have thicknesses of 0.5 mm or 3 mm specified in indentation fracture method (IF method) according to JIS R1610-2003 (ISO 14705:2000 (MOD)) and JIS R1607-1995, the thickness of each of the specimens is set to the thickness of the ceramic sintered body as it is, and evaluations are performed. The evaluation results preferably satisfy the values described above. In the case where the ceramic sintered body is too thin to satisfy the values described above when the evaluations are performed using the thickness as it is, for example, when the thickness is 0.2 mm or more and less than 0.5 mm, the Vickers hardness (Hv) and the fracture toughness (K_{1C}) may be measured provided that each of a test force and an indentation load is 0.245 N and that the holding time of each of the test force and indentation load is 15 seconds.

With respect to electrical properties of the ceramic sintered body, the ceramic sintered body preferably has a volume resistivity of 10¹⁴ Ω·cm or more at room temperature and 10¹² Ω·cm or more at 300°C. The volume resistivity may be measured with reference to JIS C2141-1992. In the case where the ceramic sintered body is small and where a specimen cannot have a size specified in JIS C2141-1992, the electrical properties are evaluated by a two-terminal method. The evaluation results preferably satisfy the values described above.

The three-point bending strength, the dynamic elastic modulus, the Vickers hardness (Hv), the fracture toughness (K_{1C}), and the volume resistivity of the supporting substrate 1, composed of the ceramic sintered body constituting the circuit board 10 may be determined by the foregoing methods after the circuit members 2, the heat-dissipating member 5, and the joining layers 3a to 3c are removed from the circuit board 10 by etching, or the like.

Next, an exemplary method for producing a circuit board according to the present embodiment will be described below with reference to Fig. 2.

A ceramic sintered body serving as the supporting substrate 1 consntituting the circuit board 10 is prepared, the ceramic sintered body having a length (in the X direction in the figure) of 20 mm or more and 220 mm or less, a width (in the Y direction in the figure) of 10 mm or more and 120 mm or less, and a thickness of 0.2 mm or more and 1.0 mm or less and being containing aluminum oxide, silicon nitride, aluminum nitride, or zirconium oxide as a principal component. The supporting substrate 1 is subjected to heat treatment at 800°C or more and 900°C or less to remove organic substances and residual carbon adhering to surfaces of the supporting substrate 1.

Then, an example of an active metal brazing method serving as a joining method will be described below. A paste of a brazing material which contains, for example, copper and tin, or silver and copper as a principal component and which contains at least one active metal selected from titanium, zirconium, hafnium, and niobium is applied on a main surface of the supporting substrate 1 by screen printing, roll coating, or brush coating. In the case where joining is performed by the active metal brazing method, non-metallic components constituting the supporting substrate 1 react with the active metal to increase the bonding strength between the supporting substrate 1 and the circuit members 2.

In the case where the brazing material is containing copper and tin as a principal component, the brazing material may contain, for example, 5% by mass or more and 18% by mass or less silver in addition to the active metal. Copper is more bondable to silver than the active metal, and the resulting compound of copper and silver is not easily embrittled, compared with a compound of the active metal and copper. Thus, the bonding strength between the supporting substrate 1 and the circuit members 2 is not easily reduced. Furthermore, the brazing material has a viscosity such that the amount of the brazing material flowing unnecessarily is small from joined portions between the supporting substrate 1 and the circuit members 2.

In addition, in the case where the brazing material contains silver and copper as principal components, the brazing material may contain, for example, at least one metal selected from indium, zinc, and tin and may contain at least one metal selected from molybdenum, osmium, rhenium, and tungsten, in addition to the active metal. In this case, the brazing material has satisfactory flowability because the at least one metal selected from indium, zinc, and tin has a low melting point and is easily melted. It is thus possible to reduce voids (voids formed by the fact that the brazing material fails to extend appropriately) between the joining layers 3a and 3b composed of the brazing material and the supporting substrate 1. The presence or absence of the voids may be determined by ultrasonic inspection. The at least one metal selected from molybdenum, osmium, rhenium, and tungsten has a high melting point and is not easily melted. The presence of the at least one selected from indium, zinc, and tin suppresses an excessive reduction in viscosity, thereby controlling the unnecessary flowing off from the joined portions.

The principal components in the brazing material indicate components that account for more than 50% by mass in total with respect to 100% by mass of the total amount of all components constituting the brazing material. The brazing material used here indicates a solder (hard solder) which is defined by JIS Z3001-3 (ISO 857-2005 (MOD)), which is used for brazing, and which has a melting point of 450°C or higher and does not include a solder (soft solder) which is defined by the foregoing specifications, which is used for soldering, and which has a melting point of less than 450°C.

Now, an exemplary method for forming the circuit member 2 including the first region having a first average grain size and the second region which is located closer to the mounting surface side than the first region and which has a second average grain size smaller than the first average grain size will be described below. First copper members are prepared and arranged on the brazing material. Heating is performed in a vacuum atmosphere at 800°C or higher and 900°C or lower to join the first copper members to one main surface of the supporting substrate 1 with the joining layers 3a and 3b composed of the brazing material. After surfaces of the joined first copper members are polished, second copper members are arranged on the respective first copper members.

Then, heating is performed in an atmosphere selected from hydrogen, nitrogen, neon, or argon at 300°C or higher and 500°C or lower under a pressure of 30 MPa or moreto join the one main surface of the supporting substrate 1 with the joining layers 3a and 3b to the first copper members, and further to the second copper members, thereby providing the circuit board 10 to which the circuit members 2 including the first copper members and the second copper members are joined. In this structure, it is important that copper as a principal component of the first copper members to be formed into the first regions have a larger average grain size than copper as a principal component of the second copper members to be formed into the second regions.

In the first copper members before joining and the second copper member before joining, the second copper members before joining preferably have a smaller average grain size than the first copper members before joining. This results in a reduction in the effect of the warpage of the second copper members on the warpage of the supporting substrate 1 because the second copper members have higher stiffness than the first copper members and thus the warpage of the second copper members due to heat during the joining is low. The first copper members have a larger average grain size. The first copper members before joining have a low yield stress and thus are easily plastically deformed by heating during joining, thereby increasing the bonding strength between the first copper members and the second copper members. As a result, bonding strength between the components included in the circuit board 10 is high and warpage of the supporting substrate 1 is low, thereby making the circuit board 10 to able to have high reliability.

In addition, in the relationship between the first copper members and the second copper members, the surface roughness of the second copper members is preferably higher than that of the first copper members at the time of joining. This is because in the first copper members and the second copper members to be joined, the second copper members having high surface roughness are pressed against the first copper members having low yield stress under heating, thereby increasing the bonding strength.

Alternatively, a direct joining method may be employed as the joining method. In this case, when a principal component of the ceramic sintered body is an oxide ceramic, the ceramic sintered body can be used as it is. When the ceramic sintered body is composed of a non-oxide ceramic, it is necessary to form an oxide layer on its surface in advance. The first copper members are arranged on the oxide layer formed on the one main surface of the oxide ceramic or on the one main surface of the non-oxide ceramic and heated to a temperature equal to or higher than the eutectic temperature of copper-copper oxide under pressure. A liquid layer of a formed Cu-O eutectic compound serves as a joining material. Thereby, the first copper members can be joined to the one main surface of the supporting substrate 1 composed of the ceramic sintered body. The first copper members and the second copper members are joined together in the same method described above, thereby providing the circuit board 10 to which the circuit members 2 including the first copper members and the second copper members are joined.

In the direct joining method, however, heating must be performed to a temperature higher than 1000°C. The supporting substrate 1 is highly likely to warpage at the time of joining. Thus, joining is preferably performed by the active metal brazing method. The joining of the first copper members and the second copper members provides the thick circuit members 2. Each of the first copper members has a thickness of, for example, 0.1 mm or more and 0.6 mm or less. Each of the second copper members has a thickness of, for example, 0.5 mm or more and 5 mm or less.

To achieve an average grain size of more than 0.1 mm and 0.5 mm or less in the first regions, the first copper members may have an average grain size of 0.02 mm or more and 0.08 mm or less according to the foregoing joining conditions.

To achieve an average grain size of 0.1 mm or less (excluding 0 µm) in the second regions, the second copper members may have an average grain size of 0.02 mm or less (excluding 0 µm) according to the foregoing joining conditions.

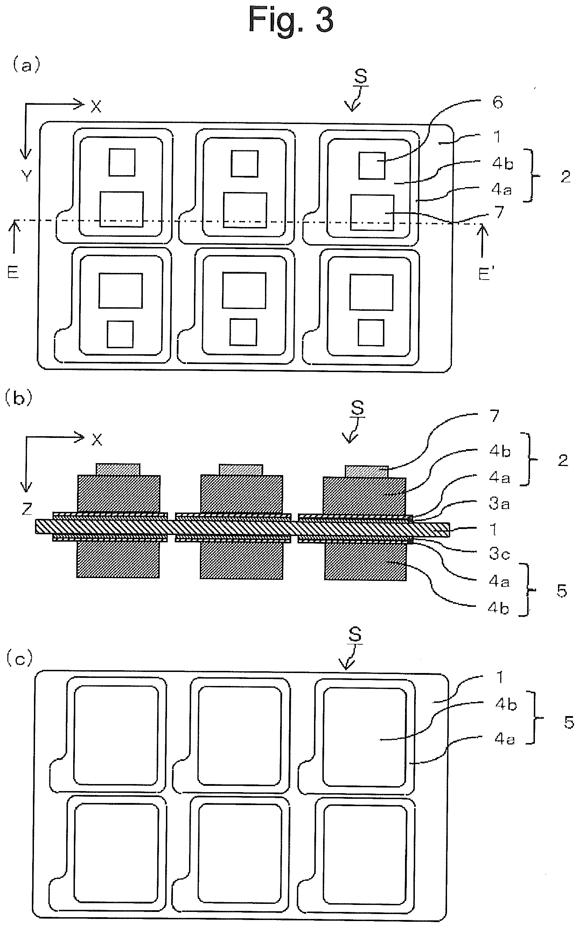

Fig. 3 shows an exemplary electronic device according to a present embodiment, (a) being a plan view, (b) being a cross-sectional view taken along line C-C' in (a), and (c) being a bottom plan view.

Fig. 3 shows an exemplary electronic device according to the present embodiment, (a) being a plan view, (b) being a cross-sectional view taken along line E-E' in (a), and (c) is a bottom plan view.

In an electronic device S exemplified in Fig. 3, one or more electronic components 6 and 7 are mounted on the circuit members 2 of the circuit board 10 according to the present embodiment. The electronic components 6 and 7 are electrically connected to each other with conductors (not illustrated). In the electronic device S, the electronic components 6 and 7 are mounted on the circuit members 2 of the circuit board 10 according to the present embodiment. Even if heat is repeatedly generated from the electronic components 6 and 7, the warpage of each member is low. Thus, the supporting substrate 1, the circuit members 2, and the heat-dissipating member 5 are not easily detached. Thereby, the electronic device S has high durability.

The electronic components 6 and 7 are, for example, semiconductor elements, such as insulated gate bipolar transistor (IGBT) elements, intelligent power module (IPM) elements, metal oxide semiconductor field-effect transistor (MOSFET) elements, light-emitting diode (LED) elements, freewheeling diode (FWD) elements, and giant transistor (GTR) elements, and head elements for dye sublimation thermal printers, head elements for thermal ink-jet printers, and Peltier elements.

In the electronic device S, the electronic components 6 and 7 are mounted on the circuit members 2 of the circuit board 10 according to the present embodiment. The circuit board 10 according to the present embodiment has high durability because even if heat is repeatedly generated from the electronic components 6 and 7, the supporting substrate 1, the circuit members 2, and the heat-dissipating member 5 are not easily detached. Thus, the highly reliable electronic device can be provided.

The shape, the external dimensions, and the thickness of the supporting substrate 1 exemplified in Fig. 3 are the same as those of the supporting substrate 1 constituting the circuit board 10 illustrated in Figs. 1 and 2. As illustrated in Fig. 3, the circuit members 2 and the heat-dissipating members 5 are preferably arranged, for example, in a plurality of rows and a plurality of columns in plan view. In the case where the circuit members 2 and the heat-dissipating members 5 are arranged in the plurality of rows and the plurality of columns in plan view, when the circuit members 2 and the heat-dissipating members 5 are joined to the supporting substrate, stresses produced in the supporting substrate 1 are easily distributed, thereby suppressing the warpage of the supporting substrate 1. In particular, preferably, the circuit members 2 and the heat-dissipating members 5 are arranged in the plurality of rows and the plurality of columns at regular intervals in plan view as illustrated in Fig. 3.

The circuit board 10 constituting the electronic device S exemplified in Fig. 3 includes the circuit members 2 joined to the supporting substrate 1 with the joining layers 3a composed of the brazing material; and the heat-dissipating members 5 joined to the supporting substrate 1 with the joining layer 3c. In the circuit members 2 and the heat-dissipating members 5, first copper members 4a are first joined, and then second copper members 4b are joined. Mounting the electronic components on the circuit members 2 of the circuit board 10 according to the present embodiment provides the electronic device S according to the present embodiment.

While examples of the present invention will be specifically described below, the present invention is not limited to these examples.

### EXAMPLE 1

Circuit boards 10 described below were produced. A heat-cycle test was performed to evaluate reliability against heat. In descriptions of dimensions of members, arrows and symbols indicating directions illustrated in the figures are used.

Supporting substrates 1 were prepared, each of the supporting substrates 1 having a length in the X direction of 60 mm, a length in the Y direction of 30 mm, and a thickness of 0.32 mm, and being formed of a ceramic sintered body containing silicon nitride. Heat treatment of each of the supporting substrates 1 at 800°C or higher and 900°C or lower resulted in the removal of organic substances and residual carbon adhering to surfaces of each supporting substrate 1. Subsequently, a paste of a brazing material (Ag: 51.5% by mass, Cu: 40% by mass, Sn: 3% by mass, Ti: 2.5% by mass, and Mo: 3% by mass) was applied to one main surface of each of the supporting substrates 1 by screen printing. First copper members 4a containing copper as a principal component, and having an average grain size described in Table 1 were arranged on the brazing material. Heating was performed in a vacuum atmosphere at 840°C to form joining layers 3a and the first copper members 4a on the one main surface of the supporting substrate 1.

After surfaces of the first copper members 4a were polished, second copper members 4b containing copper having an average grain size described in Table 1 as a principal component were arranged on the respective first copper members 4a. Heating was performed in a hydrogen atmosphere at 350°C under a pressure of 30 MPa or more to produce the circuit board 10 in which the circuit members 2 including the first copper members 4a and the second copper members 4b were joined to the one main surface of the supporting substrate 1 with the joining layers 3a. A side of a mounting surface of each of the circuit members 2 is 24 mm. Each of the first copper members 4a has a thickness of 0.35 mm. Each of the second copper members 4b has a thickness of 1.15 mm. Each of the circuit members 2 has a thickness of 1.5 mm.

The resulting circuit boards 10 were subjected to a heat-cycle test. The presence or absence of a crack formed in each supporting substrate 1 at 3000 cycles was checked with an optical microscope at a magnification of ×500. After 3000 cycles, the presence or absence of a crack formed in the supporting substrate 1 was checked at every 100 cycles in the same way as described above. Table 1 illustrates numbers of cycles when a crack was observed. One cycle was defined as a cycle in which the temperature was reduced from room temperature to -45°C, held for 15 minutes, increased to 125°C, held for 15 minutes, and reduced to room temperature.

The average grain sizes of the first copper members 4a and the second copper members 4b before and after joining were determined by a cut method described in JIS H0501-1986 (ISO 2624-1973). Table 1 illustrates the measurement values. As pretreatment, the circuit members 2 were polished by a cross-section polishing method, and the resulting polished surfaces were chemically etched by immersion in a solution at 40°C for 1 minute, the solution containing 50% by volume of aqueous hydrogen peroxide mixed with 50% by volume of dilute sulfuric acid. The resulting chemically etched surfaces were subjected to measurement.

**[Table 1]**

| Sample No. | Average grain size (mm) | | | | Number of cycles |
|---|---|---|---|---|---|
| | First copper member before joining | Second copper member before joining | First copper member after joining | Second copper member after joining | |
| 1 | 0.09 | 0.35 | 0.6 | 0.7 | 2500 |
| 2 | 0.09 | 0.3 | 0.6 | 0.6 | 2500 |
| 3 | 0.09 | 0.25 | 0.6 | 0.5 | 3300 |
| 4 | 0.09 | 0.2 | 0.6 | 0.4 | 3900 |
| 5 | 0.09 | 0.15 | 0.6 | 0.3 | 3700 |
| 6 | 0.09 | 0.1 | 0.6 | 0.2 | 3400 |

As illustrated in Table 1, comparing the average grain sizes of the first copper members 4a after joining with the average grain sizes of the second copper members 4b after joining revealed that the numbers of cycles of sample Nos. 3 to 6, in which the average grain sizes of the second copper members 4b were smaller than those of the first copper members 4a, were higher than those of sample Nos. 1 and 2, in which the average grain sizes of the first copper members 4a after joining were smaller or equal to those of the second copper members 4b after joining. This demonstrated that in the environment of the heat-cycle test, the warpage of the circuit members 2 was low, thus reducing the effect of the warpage of the circuit members 2 on the warpage of the supporting substrate 1.

Measurement of the peel strength of each of sample Nos. 2 and 3 with reference to JIS C6481-1996 revealed that sample No. 3 had higher peel strength. The results demonstrated that the average grain size of the second copper members 4b after joining was smaller than that of the first copper members 4a after joining and thus increased the bonding strength.

### EXAMPLE 2

Next, circuit boards 10 described below were produced. The reliability of the circuit boards 10 was evaluated when the circuit boards 10 were exposed to high-temperature heat.

Ceramic sintered bodies, containing silicon nitride as a principal component, having the same size as the supporting substrates 1 used in EXAMPLE 1 were prepared. The circuit boards 10 were produced in the same way as in EXAMPLE 1. A paste of a brazing material containing 55% by mass Ag, 36.5% by mass Cu, 3% by mass Sn, 2.5% by mass Ti, and 3% by mass Mo was used as a brazing material applied to one main surface of the supporting substrate 1. First copper members 4a containing copper having an average grain size described in Table 2 as a principal component were used. Second copper members 4b containing copper having average grain sizes described in Table 2 as a principal component were used. Here, the average grain sizes described in Table 2 were determined in the same way as in EXAMPLE 1.

The resulting samples were held at 260°C for 5 minutes in a forming gas or nitrogen gas atmosphere. The maximum height R_{Z} of each supporting substrate 1 in the longitudinal direction was measured with a stylus profilometer with reference to JIS B0601-2001 (ISO 4287-1997). The resulting measurements were defined as values of warpage. The measured length, the cut-off value, the tip radius of the stylus, and the scan speed of the stylus were 55 mm, R + W, 2 µm, and 1 mm/sec, respectively. Table 2 illustrates the results.

**[Table 2]**

| Sample No. | Average grain size (mm) | | | | Warpage (µm) |
|---|---|---|---|---|---|
| | First copper member before joining | Second copper member before joining | First copper member after joining | Second copper member after joining | |
| 7 | 0.05 | 0.03 | 0.3 | 0.2 | 104 |
| 8 | 0.05 | 0.02 | 0.3 | 0.1 | 89 |
| 9 | 0.05 | 0.015 | 0.3 | 0.08 | 75 |
| 10 | 0.05 | 0.01 | 0.3 | 0.06 | 62 |

As illustrated in Table 2, the results demonstrated that in sample Nos. 8 to 10, the average grain sizes of the second copper member 4b (second region) were 0.1 mm or less, and the warpage of the circuit members 2 was low, thus reducing the effect of the warpage of the circuit members 2 on the warpage of the supporting substrate 1.

### EXAMPLE 3

Next, circuit boards 10 described below were produced. The bonding strength between the circuit members 2 and the supporting substrate 1 and the reliability against heat were evaluated.

Ceramic sintered bodies, containing silicon nitride as a principal component, having the same size as the supporting substrates 1 used in EXAMPLE 1 were prepared. The circuit boards 10 were produced in the same way as in EXAMPLE 1. A paste of a brazing material containing 53% by mass Ag, 38.5% by mass Cu, 3% by mass Sn, 2.5% by mass Ti, and 3% by mass Mo was used as a brazing material applied to one main surface of each supporting substrate 1. First copper members 4a containing copper having average grain sizes described in Table 3 as a principal component were used. Second copper members 4b containing copper having an average grain size described in Table 3 as a principal component were used. Here, the average grain sizes described in Table 3 were determined in the same way as in EXAMPLE 1.

The peel strength was measured in the same way as in EXAMPLE 1 with reference to JIS C6481-1996 (IEC 249-1 (1982)). Table 2 illustrates measured values of the peel strength. The bonding strength between the circuit members 2 and the supporting substrates 1 was evaluated on the basis of the values of the peel strength. Values of the warpage of the supporting substrates 1 were measured in the same way as in EXAMPLE 2. Table 3 illustrates the results.

**[Table 3]**

| Sample No. | Average grain size (mm) | | | | Warpage (µm) | Peel strength (KN/m) |
|---|---|---|---|---|---|---|
| | First copper member before joining | Second copper member before joining | First copper member after joining | Second copper member after joining | | |
| 11 | 0.09 | 0.015 | 0.6 | 0.08 | 65 | 31 |
| 12 | 0.08 | 0.015 | 0.5 | 0.08 | 75 | 35 |
| 13 | 0.05 | 0.015 | 0.3 | 0.08 | 85 | 36 |
| 14 | 0.02 | 0.015 | 0.11 | 0.08 | 90 | 37 |
| 15 | 0.015 | 0.015 | 0.09 | 0.08 | 104 | 38 |

As illustrated in Table 3, the peel strength and the warpage increased as the average grain sizes of the first copper members 4a degreased. Preferably, the peel strength is high, and the warpage is low. The results demonstrated that each of the first copper members 4a preferably had an average grain size of more than 0.1 mm and 0.5 mm or less.

### EXAMPLE 4

The thermal conductivity and the three-point bending strength of supporting substrates 1 composed of ceramic sintered bodies having different principal components were determined. The supporting substrates 1 composed of ceramic materials containing aluminum oxide, silicon nitride, aluminum nitride, and zirconium oxide as a principal component were produced. The thermal conductivity and the three-point bending strength of each sample were measured with reference to JIS R1611-1997 and JIS R1601-2008 (ISO 17565:2003 (MOD)). Table 4 illustrates the measurements.

**[Table 4]**

| Sample No. | Principal component of supporting substrate | Thermal conductivity (W/(m·K)) | Three-point bending strength (MPa) |
|---|---|---|---|
| 16 | Al₂O₃ | 34 | 380 |
| 17 | Si₃N₄ | 58 | 820 |
| 18 | AlN | 150 | 310 |
| 19 | ZrO₂ | 3 | 1470 |

As illustrated in Table 4, in sample Nos. 16 to 18, the supporting substrates 1 were composed of the ceramic materials containing aluminum oxide, silicon nitride, aluminum nitride, and zirconium oxide as a principal component. In each sample, the thermal conductivity was 34 W/(m·K) or more, and the three-point bending strength was 310 MPa or more. It is found that the thermal and mechanical properties required for the supporting substrate 1 of the circuit board 10 were satisfied.

Furthermore, in the case where electronic components were mounted on circuit members of such a good circuit board according to the present embodiment, a highly reliable electronic device was produced without causing failure over a long period of time.

### Reference Signs List

1 supporting substrate
2, 2a, 2b circuit member
3a, 3b, 3c joining layer
4a first copper member
4b second copper member
5 heat-dissipating member
10 circuit board

## Claims

1. A circuit board (10) in which a circuit member (2) containing copper as a principal component is located on a first main surface of a supporting substrate (1), and the circuit member (2) comprises a mounting surface thereon for an electronic component, wherein
the circuit member (2) comprises:
a first region having a first average grain size; and
a second region located closer to the mounting surface side than the first region,
**characterised in that**
the second region has a second average grain size smaller than the first average grain size.

2. The circuit board (10) according to Claim 1, wherein the second region has an average grain size of 0.1 mm or less excluding 0 µm.

3. The circuit board (10) according to Claim 1 or 2, wherein the first region has an average grain size of more than 0.1 mm and less than or equal to 0.5 mm.

4. The circuit board (10) according to any one of Claims 1 to 3, wherein a heat-dissipating member (5) is provided located on a second main surface of the supporting substrate (1) opposite to the first main surface.

5. The circuit board (10) according to any one of Claims 1 to 4, wherein the supporting substrate (1) comprises a ceramic sintered body, that comprises aluminum oxide, silicon nitride, or aluminum nitride as a principal component.

6. An electronic device (S) comprising an electronic component located on the mounting surface of the circuit member (2) of the circuit board (10) according to any one of Claims 1 to 5.

## Patentansprüche

1. Eine Leiterplatte (10), bei der ein Schaltungselement (2), das Kupfer als einen Hauptbestandteil enthält, auf einer ersten Hauptfläche eines Trägersubstrats (1) angeordnet ist und das Schaltungselement (2) darauf eine Montagefläche für eine elektronische Komponente aufweist, wobei
das Schaltungselement (2) aufweist:
einen ersten Bereich, der eine erste durchschnittliche Korngröße hat, und
einen zweiten Bereich, der näher bei der Montageflächenseite als der erste Bereich angeordnet ist,
**dadurch gekennzeichnet, dass**
der zweite Bereich eine zweite durchschnittliche Korngröße hat, die kleiner als die erste durchschnittliche Korngröße ist.

2. Die Leiterplatte (10) gemäß Anspruch 1, wobei der zweite Bereich eine durchschnittliche Korngröße von 0,1 mm oder weniger, ausgenommen 0 µm hat.

3. Die Leiterplatte (10) gemäß Anspruch 1 oder 2, wobei der erste Bereich eine durchschnittliche Korngröße von größer als 0,1 mm und kleiner oder gleich 0,5 mm hat.

4. Die Leiterplatte (10) gemäß irgendeinem der Ansprüche 1 bis 3, wobei ein Wärmeabführelement (5) vorgesehen ist, das auf einer zweiten Hauptfläche des Trägersubstrats (1) entgegengesetzt zu der ersten Hauptfläche angeordnet ist.

5. Die Leiterplatte (10) gemäß irgendeinem der Ansprüche 1 bis 4, wobei das Trägersubstrat (1) einen Keramiksinterkörper aufweist, der Aluminiumoxid, Siliciumnitrid oder Aluminiumnitrid als einen Hauptbestandteil aufweist.

6. Eine elektronische Vorrichtung (S), aufweisend eine elektronische Komponente, die sich auf der Montagefläche des Schaltungselements (2) der Leiterplatte (10) gemäß irgendeinem der Ansprüche 1 bis 5 befindet.

## Revendications

1. Un circuit imprimé (10), dans lequel un élément de circuit (2) contenant du cuivre comme composant principal est situé sur une première surface principale d'un substrat de support (1), et l'élément de circuit (2) comprend une surface de montage sur celle-ci pour un composant électronique, dans lequel
l'élément de circuit (2) comprend :
une première région ayant une première taille moyenne de grain, et
une deuxième région située plus proche du côté de surface de montage que la première région,
**caractérisé en ce que**
la deuxième région a une deuxième taille moyenne de grain inférieure à la première taille moyenne de grain.

2. Le circuit imprimé (10) selon la revendication 1, dans lequel la deuxième région a une taille moyenne de grain de 0,1 mm ou moins à l'exclusion de 0 µm.

3. Le circuit imprimé (10) selon la revendication 1 ou 2, dans lequel la première région a une taille moyenne de grain de plus de 0,1 mm et inférieure ou égale à 0,5 mm.

4. Le circuit imprimé (10) selon l'une quelconque des revendications 1 à 3, dans lequel un élément de dissipation de chaleur (5) est prévu de manière à être disposé sur une deuxième surface principale du substrat de support (1) opposée à la première surface principale.

5. Le circuit imprimé (10) selon l'une quelconque des revendications 1 à 4, dans lequel le substrat de support (1) comprend un corps fritté céramique qui comprend de l'oxyde d'aluminium, du nitrure de silicium ou du nitrure d'aluminium comme composant principal.

6. Un dispositif électronique (S), comportant un composant électronique situé sur la surface de montage de l'élément de circuit (2) du circuit imprimé (10) selon l'une quelconque des revendications 1 à 5.
